# EUROPEAN PATENT SPECIFICATION

(11) **EP 4 402 802 B1**
(45) Date of publication and mention of the grant of the patent: **06.05.2026**
(21) Application number: 22769219.1
(22) Date of filing: 25.08.2022
(51) Int. Cl.: H03K 17/22, G06F 1/24

(54) **RESET DEVICE**
RÜCKSETZVORRICHTUNG
DISPOSITIF DE RÉINITIALISATION

(30) Priority: 16.09.2021 GB 202113242
(43) Date of publication of application: 24.07.2024
(73) Proprietor: Hunter Douglas Industries B.V., 3011 GB Rotterdam (NL)
(72) Inventor: LILIENTHAL, Heiko, 3008 AB Rotterdam (NL)
(74) Representative: J A Kemp LLP
(86) International application number: PCT/EP2022/073685
(87) International publication number: WO 2023/041303

(56) References cited:
- WO-A1-2020/133246
- CN-A- 112 072 746
- CN-U- 204 697 033
- US-A1- 2005 231 874
- US-A1- 2022 337 237

## Description

The present application relates to a reset device for resetting a controller of a motor, and to a motor assembly comprising a reset device.

It is sometimes necessary for a controller of a device such as a motor to be reset, for example in the event of software or firmware malfunctions. Where the device is powered by a permanently installed battery, the user needs the option to manually trigger a reset of the controller. Additionally, such devices may be supplied in a sleep state to conserve power, which requires a reset signal to transition into an operating state.

Conventionally resetting is achieved by providing a physical reset button for the user to press. However, this requires physical space for a button on the outer casing of the product into which the motor is incorporated. For products such as motorised blinds the available space may be limited. Furthermore, a physical button typically requires a long reset line, which may be vulnerable to external electromagnetic signals. There is therefore a need for an alternative approach to resetting controllers of motors.

US 2005/231874 A1, WO 2020/133246 A1, CN 204 697 033 U and CN 112 072 746 A disclose background art.

In accordance with a first aspect of the invention there is provided a reset device for resetting a controller of a motor, the device comprising: a first delay circuit configured to discharge a first voltage; a second delay circuit configured to discharge a second voltage; and a reset circuit configured to provide a reset signal to the controller; wherein the first delay circuit and second delay circuit are arranged to be charged from a physical connector, and to discharge upon removal of the physical connector; and wherein the first delay circuit triggers the reset circuit to provide the reset signal when the first voltage meets a first threshold condition relative to the second voltage.

Such a device enables a reset of the controller (e.g. microcontroller) to be triggered by insertion and removal of a physical connector, such as a USB connector. This avoids the need for a physical reset button, whilst still providing the user with the ability to manually trigger a reset of the controller. The physical connector is preferably the same physical connector used to charge an internal battery powering the motor, reducing the physical space required on the outside of the product incorporating the motor. This also means that the reset pulse is triggered when the battery has just been charged, providing a stable charge for the resetting of the controller. Furthermore, as the reset device can be located close to the controller, the reset line can be shorter than may be possible for a physical reset button. This provides greater EMC protection.

Further advantageously, such a reset device can be constructed of only analogue components. The trigger for the reset pulse is provided by the varying voltages output by the first and second delay circuits. The first and second voltages output by the delay circuits drop in response to the removal of the charging voltage from the physical connector. No digital components are required to provide the varying voltages or trigger the reset pulse, and no additional voltage lines are needed to power the first and second delay circuits. Using analogue components simplifies the circuit design, and draws less energy from the battery than would be required by digital components.

As used herein, the term circuit includes both a complete circuit and parts of a larger circuit performing a particular function, such as the first delay circuit and second delay circuit.

**In** some embodiments the reset device comprises a first switching element switchably connecting the first delay circuit to the reset circuit, wherein the first switching element is configured to connect the first delay circuit to the reset circuit only if the first voltage meets the first threshold condition. The first switching element may be a first transistor gated by the second delay circuit such that the first delay circuit is connected to the reset circuit when the first threshold condition is met. **In** particular the first transistor may be a MOSFET, such as a p-type MOSFET. Such a transistor allows the first threshold condition to be implemented with a single, analogue component.

The first threshold condition is that the first voltage exceeds the second voltage by a minimum amount. The minimum amount may be a hysteresis voltage of the first switching element, such as a hysteresis voltage of the first transistor.

In some embodiments, the reset circuit is configured to provide the reset signal to the controller only when the first voltage meets a second threshold condition. The second threshold condition may be that the first voltage is greater than a fixed amount. In this way, the reset device is able to both trigger and stop a reset signal. In other words, the reset device can trigger a reset pulse. The length of the reset pulse can be selected as desired by appropriate choice of the second threshold condition, and voltage decay rate of the first delay circuit. This can be achieved using only analogue components, and so the reset device provides a simple, low power way of triggering a reset pulse for a controller of a motor.

In some embodiments, the reset voltage is low, ground, or 0V. In other words, the reset circuit may be configured, when the first (and optionally second) threshold condition is met, to connect the reset connector of a controller to a low, ground, or 0V line. Using a "low active" reset voltage allows the reset device to be designed as an open drain, preventing a reverse current when a reset pulse is not being generated.

The first delay circuit is configured to discharge the first voltage at a first rate, and the second delay circuit is configured to discharge the second voltage at a second rate, wherein the first rate is slower than the second rate. The maximum value of the first voltage stored by the first delay circuit is less than the maximum value of the second voltage stored by the second delay circuit. For example the first delay circuit may comprise a resistor arranged to reduce a voltage supplied from the physical connector to a voltage storage element (e.g. a capacitor) of the first delay circuit.

A combination of lower initial voltage and slower discharge rate of the first delay circuit compared to the second delay circuit provides a simple mechanism of ensuring that a reset signal is not triggered whilst the physical connector is in place, whilst advantageously also providing a short period after removal of the physical connector and before the reset signal is triggered. The controller can use this short period to complete any running processes before being reset.

In some embodiments the reset circuit is a first reset circuit for providing a reset signal to a first controller, and the reset device further comprises a second reset circuit for providing a reset signal to a second controller, wherein the first delay circuit is configured to trigger the first reset circuit and second reset circuit to provide the respective reset signals when the first voltage meets a first threshold condition relative to the second voltage. Thus a single reset device can be used to trigger resets of multiple controllers, saving on space required for the reset circuitry.

According to a second aspect of the invention there is provided a motor assembly comprising: a motor; a controller for controlling the motor; a port for receiving a voltage-supplying physical connector; and a reset device according to any embodiment of the first aspect arranged to receive a voltage from a physical connector received in the port, and to provide a reset signal to the controller.

According to a third aspect of the invention there is provided a motorised blind comprising the motor assembly of any embodiment of the second aspect.

Embodiments of the invention will now be described, by way of example only, with reference to the accompanying drawings in which corresponding reference symbols indicate corresponding parts, and in which:
Fig. 1 is a schematic representation of a reset device within a motor assembly;
Fig. 2 is a circuit diagram of an example reset device;
Fig. 3a illustrates the change of the first voltage and second voltage after removal of the physical connector for the reset device of Fig. 2;
Fig. 3b illustrates the result signal generated by the reset device of Fig. 2;
Fig. 4 is a circuit diagram of an alternative example reset device; and
Fig. 5 illustrates an exemplary motorised blind comprising a reset device.

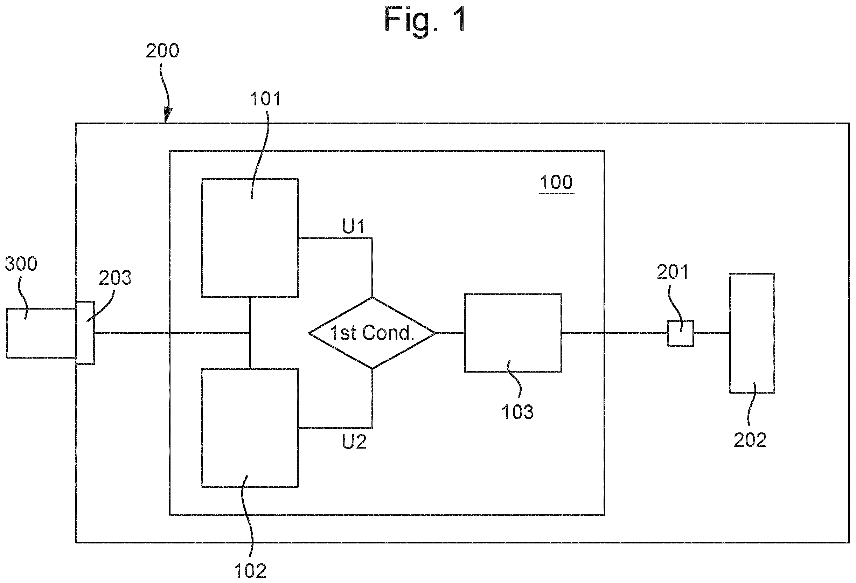

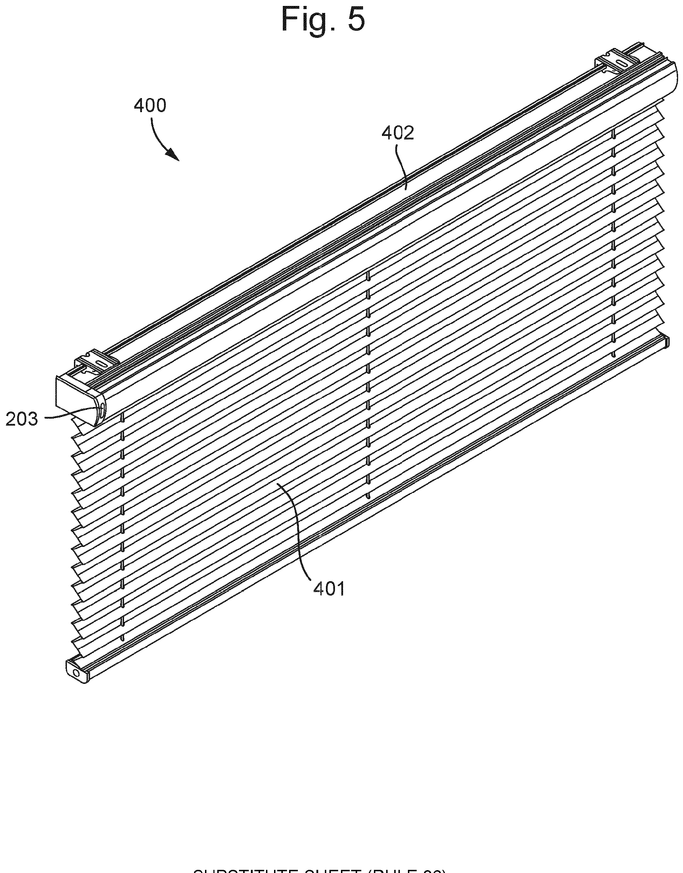

Fig. 1 illustrates an example reset device 100 for resetting a controller (e.g. microcontroller) 201 of a motor 202. Reset device 100 is illustrated as being part of a motor assembly 200 along with the controller 201 and motor 202, but it is to be appreciated that the reset device 100 may be separate from and connectable to the motor assembly 200. Motor 202 may be any type of motor, as appropriate for the intended use of the motor 202. For example motor 202 may be a DC motor 202. Motor assembly 200 may be incorporated into a product such as motorised blinds (such as motorised blind 400 of Fig. 5), where the motor 202 is configured to operate the blinds. The controller 201 may be any suitable controller for controlling operation of the motor 202.

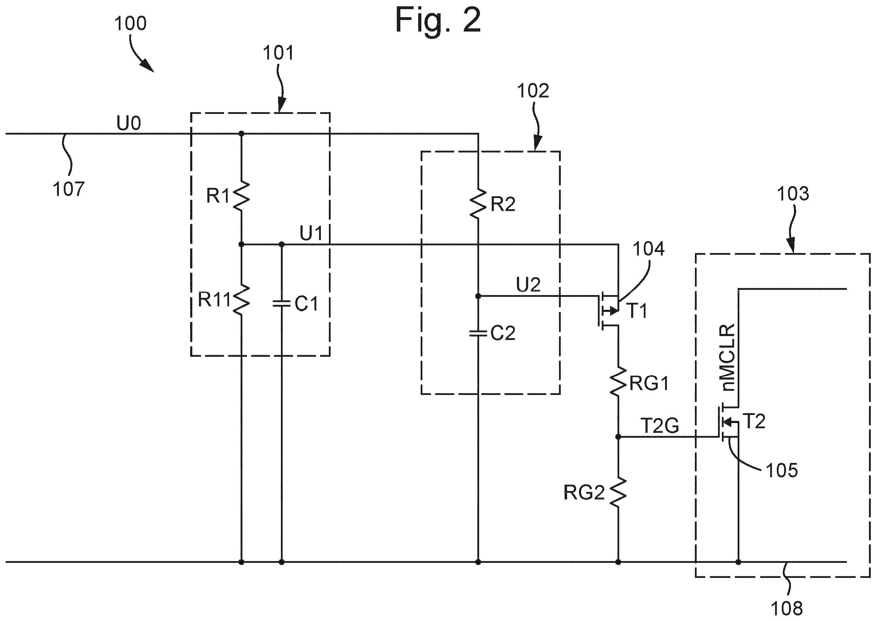

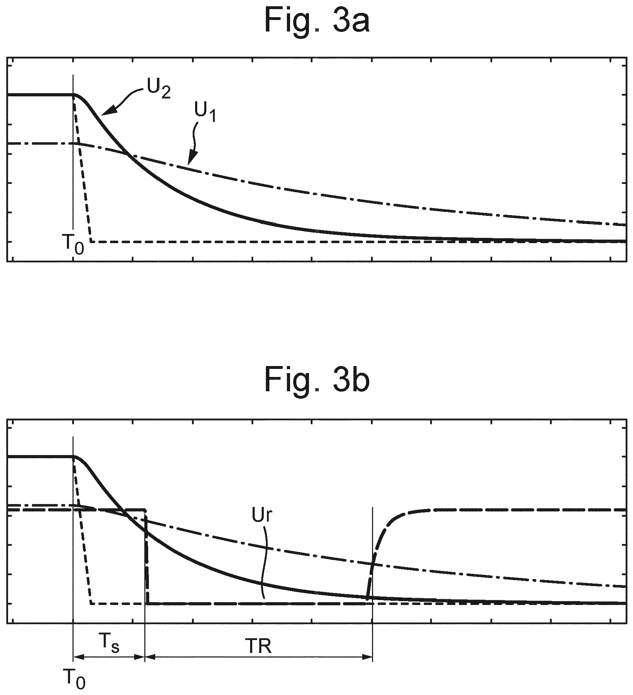

Reset device 100 comprises a first delay circuit 101 configured to discharge a first voltage, U1(t). Reset device 100 further comprises a second delay circuit 102 configured to discharge a second voltage, U2(t). In the examples shown in figs. 2 and 3 below, the first delay circuit 101 and second delay circuit comprise respective RC elements. In general the first delay circuit 101 and second delay circuit 102 may comprise any circuit component capable of discharging a stored voltage over a period of time. For example, the first delay circuit 101 and/or second delay circuit 102 may comprise a combination of one or more resistors, capacitors, and/or inductors. Advantageously, the first and second delay circuits 101, 102 (and the reset circuit 103 discussed below) may be constructed of analogue, as opposed to digital, electrical components. Analogue components allow for a simpler design that use minimal energy.

Both the first delay circuit 101 and second delay circuit 102 are arranged to be charged from a voltage-supplying physical connector 300. In some examples the physical connector is a USB connector, such as a USB-C^{®} connector. The physical connector 300 is received in a connector port 203 of the motor assembly. The first and second delay circuits 101, 102 receive a voltage from the physical connector 300 when received in the connector port 203. For example, the first and second delay circuits 101, 102 may be connected directly or indirectly to a voltage supply line from the connector port 203. Advantageously, the physical connector 300 used to charge the first and second delay circuits 101, 102 may also be used to charge an internal battery of the motor assembly 200, used for powering the motor 201.

The first and second delay circuits 101, 102 are further arranged to discharge upon removal of the physical connector 300 from the connector port 203. In particular, the first and second delay circuits 101, 102 begin to lose their charge when the charging voltage from the physical connector 300 is removed. Each delay circuit 101, 102 is configured to discharge over a respective period of time. The first delay circuit 101 is configured to discharge the first voltage U1(t) at a first rate R1, and the second delay circuit is configured to discharge the second voltage U2(t) at a second rate R2, wherein the first rate is slower than the second rate. Where the first and second delay circuits comprise respective RC elements storing and discharging the respective voltages U1(t), U2(t), the respective RC time constants provide the respective decay rates R1, R2.

Thus when the charging voltage from the physical connector 300 is removed, the first and second voltages U1(t) and U2(t) discharge at different rates. The difference between U1(t) and U2(t) at a given time after removal of the physical connector 300 is used to trigger a reset signal to reset the controller 201.

The reset signal is provided by a reset circuit 103. The reset circuit 103 is connected (or connectable) to a reset line of the controller 201. When triggered, the reset circuit 103 applies the reset signal to the reset line of the controller 201, and thereby resets the controller 201. In particular examples, the reset circuit 103 when triggered connects the reset line of the controller 201 to a reset voltage. The reset voltage may be a high voltage, but preferably the reset voltage is a low, ground, or zero voltage line. This both avoids the need for a powered reset line, and limits reverse current flow when a reset is not intentionally triggered. In such cases, the controller 201 may comprise a pull-up resistor to restore the reset line to high or "1" after the reset signal has ceased.

The reset circuit 103 is triggered to provide the reset signal by the first delay circuit 101, and in particular by the first voltage U1(t) discharged by the first delay circuit 101. The reset circuit 103 provides the reset signal if the first voltage U1(t) meets a first threshold condition relative to the second voltage U2(t). The changing voltages U1(t), U2(t) after removal of the physical connector 300 thus determine when the reset signal is issued. By appropriate selection of the respective rates of discharge of U1(t) and U2(t), the maximum values of U1(t) and U2(t), and the first threshold condition, a reset signal can be triggered at any desired point after removal of the physical connector 300. The reset signal may be triggered each time the physical connector 300 is removed, as long as the first delay circuit 101 and second delay circuit 102 are sufficiently charged to trigger the reset pulse. Alternatively there may be a minimum time for which the physical connector 300 must be inserted in order for its removal to trigger a reset pulse. The minimum time may be in the range from 0.5s to 2s, or may be approximately 1s. The minimum time may be selected based on, or determined by, the characteristics of the first and second delay circuits 101, 102. This minimum time may be implemented passively, by the requirement to charge the first and second delay circuits 101, 102 to a certain extent in order for the reset signal to be generated. Alternatively it may be actively implemented, for example by the controller 201 itself determining if the minimum time has passed since charging began, and only resetting in response to the reset signal if it has.

Fig. 2 illustrates a particular example of reset device 100, showing how a first threshold condition can be used to trigger the reset pulse. In Fig. 2, both the first delay circuit 101 and second delay circuit comprise RC elements. In particular, first delay circuit 101 comprises a resistor R1 and capacitor C1 forming a first RC element. Second delay circuit 102 comprises a resistor R2 and a capacitor C2 forming a second RC element. Both capacitors C1 and C2 are charged from voltage supply line 107, supplying a constant voltage U0. The voltage supply line 107 is connected (or connectable) to a connector port 203 to receive voltage from a physical connector 300.

The first delay circuit 101 is configured to charge to a lower maximum voltage than the second delay circuit 102. In other words, the maximum value of U1(t) before discharging is less than the maximum value of U2(t) before discharging. This is achieved in the example of Fig. 2 by reducing the charging voltage across the capacitor C1 using additional resistor R11. Thus capacitor C1 charges to a lower voltage than capacitor C2. It is to be appreciated that other examples may use any other arrangement of maximum voltages. For example both first and second delay circuits 101, 102 may reduce the charging voltage across the voltage storing element (e.g. capacitor) with appropriate resistors. In some examples the resistance of resistor R11 is at least 1.5x or at least 2x larger than the resistance of resister R1. Additionally or alternatively the resistance of resistor R11 at most 3x the resistance of R1.

In examples such as that of Fig. 2, the first threshold condition is implemented using a switching element 104. The switching element switchably connects the first delay circuit 101 to the reset circuit 103. This connection is made only if the first voltage U1(t) meets the first threshold condition. In the illustrated example the switching element 104 is a transistor T1 gated by the second delay circuit 102. Specifically, the transistor T1 may be a p-type MOSFET, with the first delay circuit connected to the source (i.e. the first voltage U1(t) is applied to the source), the second delay circuit 102 connected to the gate (i.e. the second voltage U2(t) is applied to the gate), and the drain connected to the reset circuit 103. When the transistor is switched to a conducting state, the first voltage U1(t) is applied to the reset circuit 103, and so is able to trigger the reset signal. In the illustrated example, the reset circuit 103 applies the reset signal by connecting the reset pin of the controller 201 to a ground line 108.

The first threshold condition is that the first voltage exceeds the second voltage by a minimum amount. In the case of a transistor, the minimum amount may be a hysteresis voltage Uh of the transistor T1. Thus the first threshold condition may be U1(t) > U2(t) + Uh. As in this case U2(t)>U1(t) before the physical connector 300 is removed, this arrangement ensures a reset pulse is not triggered whilst the physical connector 300 is providing a charge. Once the physical connector 300 is removed, the different discharge profiles of U1(t) and U2(t), determined in this case by the respective RC time constants of the first and second RC elements, mean that the first voltage condition is only met at certain times. Thus the triggering of the reset signal can be set as desired.

Fig. 3a illustrates the discharge curves of the first voltage U1(t) and second voltage U2(t) after removal of the physical connector at time T₀ for the example reset device 100 of Fig. 2. Fig. 3b shows the corresponding reset signal Ur generated by the reset circuit 103 in response to the first voltage U1(t). In this case the reset signal is low or '0', and so the reset signal is the 0 voltage part of the graph.

The discharge curves of U1(t) and U2(t) show exponential decay with a time constant *τ* = RC, as expected for the simple RC elements of the first and second delay circuits 101, 102 of Fig. 2. In this example R1C1 > R2C2, thus the first voltage U1(t) decays more slowly than the second voltage U2(t). As a result of the initial values of U1(t) and U2(t), and the respective RC time constants, U1(t) only meets the first threshold condition of U1(t)>U2(t)+Uh after a period of time Tₛ. Thus there is an initial period between removal of the physical connector 300 and the onset of the reset signal. This provides time to terminate any processes running in the controller 201 before the reset is initiated. For this purpose, the reset device 100 or another component of the motor assembly 200 may be configured to transmit a signal to the controller 201 upon removal of the physical connector 300, instructing the controller 201 to end running processes. The initial values of U1(t) and U2(t), and respective time constants, can be selected to provide sufficient time for the controller 201 to end processes. In some examples, the first rate of discharge of the first voltage U1(t) (e.g. 1/R1C1 for RC-based implementations) is at least 2x, or at least 3x, or at least 4x slower than the second rate of discharge of the second voltage, U2(t). Additionally or alternatively, the first rate of discharge of the first voltage U1(t) is at most 10x, or at most 7x, or at most 5x slower than the second rate of discharge of the second voltage, U2(t). As examples, the first rate may be a constant rate in a range from 0.5 to 3 s⁻¹ inclusive, or from 1 to 2 s⁻¹ inclusive. The second rate may be a constant rate in a range from 3 to 10 s⁻¹ inclusive, or from 5 to 8 s⁻¹ inclusive. The values of the components may generally be selected based on the requirements of the controller, and on the voltage supplied from the physical connector 300 (typically 5V for a USB connector 300).

In addition to triggering the reset signal, it may also be desirable to control when the reset signal stops using the reset device 100. As shown in fig. 3b, this allows the device 100 to provide a reset pulse of a desired length Tᵣ. This is achieved by setting a second threshold condition which the first voltage must meet for the reset signal to be produced by the reset circuit 103. In the illustrated example, the second threshold condition is that first voltage is greater than a fixed amount. When the first voltage U1(t) drops below the fixed amount, the reset signal ceases. The fixed amount is relatively low compared to the initial values of U1(t) and U2(t). Thus for most of the decay of U1(t), the second threshold condition is met, allowing the onset of the reset signal to be controlled by the first threshold condition. The fixed amount can be selected so that the first voltage decays for a desired period of time Tₛ+Tᵣ before reaching the fixed amount, generating a reset pulse of desired length Tᵣ. In particular, Tᵣ may be selected to be sufficiently long to safely reset the controller 201. As discussed above, for 'low active' examples where the reset signal is low, the voltage on the reset line of the controller 201 can be pulled to high after end of the reset signal, as shown in Fig 3b.

In examples such as the device 100 shown in Fig. 2, the second threshold condition can be implemented using a second switching element 105 configured to switchably connect the controller 201 to a reset voltage line 108 when the first voltage meets the second threshold condition. In the illustrated example, the second switching element is a second transistor T2. The source of the second transistor T2 is connected (or connectable) to the controller 201, and specifically to a reset pin of the controller 201. The drain of transistor T2 is connected to the reset voltage line 108, in this case a ground or low line. The gate of transistor T2 is connected to the first delay circuit 101 via the first switching element 104 (i.e. transistor T1 in the illustrated example). Thus when the first threshold voltage condition is met, the first voltage U1(t) is applied to the gate of transistor T2. As long as U1(t) is larger than the gate voltage of T2, transistor T2 will be in a conducting state, connecting the controller 201 to the reset voltage line 108 and so generating the reset signal. When the first voltage U1(t) drops below the gate voltage of T2, the connection between the controller 201 and reset voltage line 108 will be broken, ending the reset signal. Thus in this example the second threshold condition is that the first voltage is greater than the gate voltage of transistor T2.

In the above examples, a single controller 201 has been reset by the reset device 100. However, in other examples multiple controllers 201 may be resettable by the reset device 100. In some examples, each of a plurality of controllers 201 may receive the same reset signal at the same time from the reset circuit 103, for example by connecting the reset lines of each controller 201 to the second switching element 105. Alternatively, the reset device 100 may comprise multiple reset circuits 103, each connected to one or more controllers 103. Each of the reset circuits 103 is triggered by the first voltage meeting the first voltage threshold, as described above, but then control independent reset signals. In particular, this allows different lengths of reset signal to be generated for different controllers 201 by appropriate selection of respective second threshold conditions of the respective reset circuit 103.

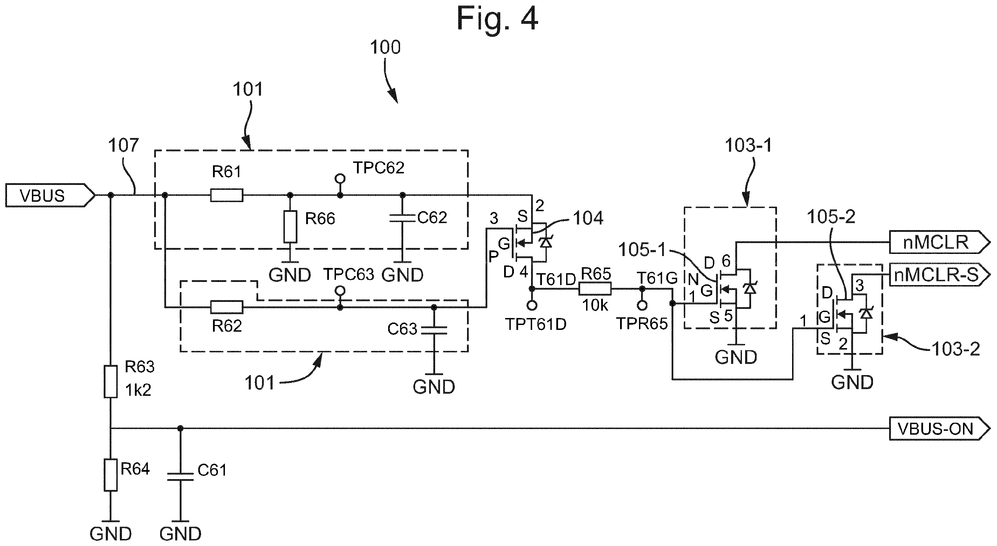

An example of a reset device 100 for resetting multiple controllers 201 is shown in Fig. 4. This reset device 100 comprises a first reset circuit 103-1 connected (or connectable) to a first controller 201 (via connection nMCLR in Fig. 3). The device 100 further comprises a second reset circuit 103-2 connected (or connectable) to a second controller 201 (via connection nMCLR-S in Fig. 3). Each reset circuit 103-1, 103-2 comprises a respective second switching element 105-1, 105-2. In this example, both second switching elements 105-1, 105-2 are transistors, gated by the first voltage U1(t) from the first delay circuit 101 as discussed above in relation to Fig. 2. The first and second delay circuits 101, 102 are substantially the same as those described in relation to Fig. 2. The second reset circuit 103-2 may set a different threshold condition to the first reset circuit 103-1, which may be termed a third threshold condition that the first voltage U1(t) must meet for the second reset circuit 103-2 to generate its respective reset signal. In this example, the transistor 105-2 may have a different gate voltage to the transistor 105-1, yielding different threshold conditions of the first and second reset circuits 103-1, 103-2. Alternatively the first and second reset circuits 103-1, 103-2 may set the same second threshold condition.

The reset devices described above thus allow a reset signal of a desired length to be generated to reset the controller or controllers of a motor. The components of the reset device that trigger a reset signal are driven using only energy from a physical connector, in particular a physical connector used to charge a battery powering the motor. As a result, the reset device 100 does not need to take energy from the battery, and has a very low impact on the battery during normal use of the motor. Furthermore, the arrangement of the device 100 can ensure that after a reset, and unless a physical connector is plugged in again, no accidental reset is possible, as the first and second voltages are depleted. Further, the arrangement of the device 100 can be such that a reset is not triggered during charging of a battery, when the controller is used as a regulator. This can be achieved passively, by appropriate selection of the maximum respective charging voltages of the first and second delay circuits. All of the components of the reset device may be implemented using analogue components, simplifying the circuit design.

Fig. 5 illustrates an example of a motorised blind 400 into which any of the reset devices discussed above may be incorporated. The motorised blind 400 comprises blinds 401 extending from a head rail 402. A motor assembly 200, comprising a reset device 100 according to any of the above examples discussed above, is held within the head rail 402. The motor assembly 200 is arranged to raise the blinds 401 towards the head rail 402 or to lower the blinds 401 away from the head rail 402. A connector port 203 is positioned on the head rail 402 to receive a physical connector 300 (e.g. a USB connector). Connector port 203 connects to rest of the motor assembly 200 within the head rail 402.

It is to be appreciated that the specific arrangement of devices 100 discussed above are for example only. In general, any combination of maximum first and second voltages, discharge rates, and first (and optionally second) threshold conditions can be selected as appropriate for a particular controller.

## Claims

1. A reset device (100) for resetting a controller (201) of a motor (202), the device comprising:
a first delay circuit (101) configured to discharge a first voltage (U1(t)) at a first rate (R1);
a second delay circuit (102) configured to discharge a second voltage (U2(t)) at a second rate (R2), wherein the first rate is slower than the second rate; and
a reset circuit (103) configured to provide a reset signal to the controller;
wherein the first delay circuit (101) and second delay circuit (102) are arranged to be charged from a physical connector (300), and to discharge upon removal of the physical connector;
the first delay circuit (101) triggers the reset circuit to provide the reset signal when the first voltage meets a first threshold condition relative to the second voltage;
the maximum value of the first voltage stored by the first delay circuit (101) is less than the maximum value of the second voltage stored by the second delay circuit (102); and
the first threshold condition is that the first voltage exceeds the second voltage by a minimum amount.

2. The reset device of claim 1, wherein the reset device comprises a first switching element (104) switchably connecting the first delay circuit (101) to the reset circuit, wherein the first switching element is configured to connect the first delay circuit (101) to the reset circuit only if the first voltage meets the first threshold condition.

3. The reset device (100) of claim 2, wherein the first switching element is a first transistor (T1) gated by the second delay circuit (102) such that the first delay circuit (101) is connected to the reset circuit when the first threshold condition is met.

4. The reset device (100) of any preceding claim, wherein the reset circuit is configured to provide the reset signal to the controller only when the first voltage meets a second threshold condition.

5. The reset device (100) of claim 4, wherein the reset circuit comprises a second switching element (105) configured to switchably connect the controller to a reset voltage, wherein the second switching element is configured to connect the controller to the reset voltage when the first voltage meets the second threshold condition.

6. The reset device (100) of claim 5, wherein the reset voltage is low, ground, or 0V.

7. The reset device (100) of claim 5 or claim 6, wherein the second threshold condition is that the first voltage is greater than a fixed amount.

8. The reset device (100) of claim 7, wherein the second switching element is a second transistor (T2) gated by the first delay circuit (101), and wherein the second threshold condition is that the first voltage is greater than a gate voltage of the second transistor.

9. The reset device (100) of any preceding claim, wherein the first delay circuit (101), the second delay circuit (103-2) and/or the reset circuit are formed of analogue components.

10. The reset device (100) of claim 9, wherein the first delay circuit (101) and/or second delay circuit (102) comprises an RC circuit.

11. The reset device (100) of any preceding claim, wherein the reset circuit is a first reset circuit for providing a reset signal to a first controller, and wherein the reset device further
comprises a second reset circuit (103-2) for providing a reset signal to a second controller (201), wherein the first delay circuit (101) is configured to trigger the first reset circuit and second reset circuit (103-2) to provide the respective reset signals when the first voltage meets a first threshold condition relative to the second voltage;
wherein, optionally, the second reset circuit (103-2) is configured to provide the respective reset signal to the second controller only if the first voltage meets a third threshold condition.

12. The reset device (100) of any preceding claim, wherein the physical connector is a USB connector.

13. A motor assembly (200) comprising:
a motor (202);
a controller for controlling the motor;
a port (203) for receiving a voltage-supplying physical connector; and
a reset device according to any of claims 1-12 arranged to receive a voltage from a physical connector received in the port, and to provide a reset signal to the controller.

14. The motor (202) of claim 13, further comprising a battery for powering the motor, wherein the battery is arranged to be charged by a physical connector received in the port.

15. A motorised blind (400) comprising the motor assembly of claim 13 or claim 14.

## Patentansprüche

1. Zurücksetzvorrichtung (100) zum Zurücksetzen einer Steuervorrichtung (201) eines Motors (202), wobei die Vorrichtung umfasst:
eine erste Verzögerungsschaltung (101), die dazu konfiguriert ist, eine erste Spannung (U1(t)) mit einer ersten Rate (R1) zu entladen;
eine zweite Verzögerungsschaltung (102), die dazu konfiguriert ist, eine zweite Spannung (U2(t)) mit einer zweiten Rate (R2) zu entladen, wobei die erste Rate langsamer ist als die zweite Rate; und
eine Zurücksetzschaltung (103), die dazu konfiguriert ist, ein Zurücksetzsignal an die Steuervorrichtung bereitzustellen;
wobei die erste Verzögerungsschaltung (101) und die zweite Verzögerungsschaltung (102) angeordnet sind, um über einen physikalischen Stecker (300) geladen zu werden und sich bei dem Entfernen des physikalischen Steckers zu entladen;
die erste Verzögerungsschaltung (101) die Zurücksetzschaltung auslöst, um das Zurücksetzsignal bereitzustellen, wenn die erste Spannung eine erste Schwellenbedingung relativ zu der zweiten Spannung erfüllt;
der Maximalwert der ersten Spannung, der von der ersten Verzögerungsschaltung (101) gespeichert wird, kleiner ist als der Maximalwert der zweiten Spannung, der von der zweiten Verzögerungsschaltung (102) gespeichert wird; und
die erste Schwellenbedingung darin besteht, dass die erste Spannung die zweite Spannung um einen Mindestwert übersteigt.

2. Zurücksetzvorrichtung nach Anspruch 1, wobei die Zurücksetzvorrichtung ein erstes Schaltelement (104) umfasst, das die erste Verzögerungsschaltung (101) schaltbar mit der Zurücksetzschaltung verbindet, wobei das erste Schaltelement dazu konfiguriert ist, die erste Verzögerungsschaltung (101) nur dann mit der Zurücksetzschaltung zu verbinden, wenn die erste Spannung die erste Schwellenbedingung erfüllt.

3. Zurücksetzvorrichtung (100) nach Anspruch 2, wobei das erste Schaltelement ein erster Transistor (T1) ist, der von der zweiten Verzögerungsschaltung (102) derart torgesteuert wird, dass die erste Verzögerungsschaltung (101) mit der Zurücksetzschaltung verbunden ist, wenn die erste Schwellenbedingung erfüllt ist.

4. Zurücksetzvorrichtung (100) nach einem der vorstehenden Ansprüche, wobei die Zurücksetzschaltung dazu konfiguriert ist, das Zurücksetzsignal nur dann an die Steuervorrichtung bereitzustellen, wenn die erste Spannung eine zweite Schwellenbedingung erfüllt.

5. Zurücksetzvorrichtung (100) nach Anspruch 4, wobei die Zurücksetzschaltung ein zweites Schaltelement (105) umfasst, das dazu konfiguriert ist, die Steuervorrichtung schaltbar mit einer Zurücksetzspannung zu verbinden, wobei das zweite Schaltelement dazu konfiguriert ist, die Steuervorrichtung mit der Zurücksetzspannung zu verbinden, wenn die erste Spannung die zweite Schwellenbedingung erfüllt.

6. Zurücksetzvorrichtung (100) nach Anspruch 5, wobei die Zurücksetzspannung niedrig, Masse oder 0 V ist.

7. Zurücksetzvorrichtung (100) nach Anspruch 5 oder 6, wobei die zweite Schwellenbedingung darin besteht, dass die erste Spannung größer als eine feste Menge ist.

8. Zurücksetzvorrichtung (100) nach Anspruch 7, wobei das zweite Schaltelement ein zweiter Transistor (T2) ist, der durch die erste Verzögerungsschaltung (101) torgesteuert wird, und wobei die zweite Schwellenbedingung darin besteht, dass die erste Spannung größer ist als eine Steuerspannung des zweiten Transistors.

9. Zurücksetzvorrichtung (100) nach einem der vorstehenden Ansprüche, wobei die erste Verzögerungsschaltung (101), die zweite Verzögerungsschaltung (103-2) und/oder die Zurücksetzschaltung aus analogen Komponenten ausgebildet sind.

10. Zurücksetzvorrichtung (100) nach Anspruch 9, wobei die erste Verzögerungsschaltung (101) und/oder die zweite Verzögerungsschaltung (102) eine RC-Schaltung umfasst.

11. Zurücksetzvorrichtung (100) nach einem der vorstehenden Ansprüche, wobei die Zurücksetzschaltung eine erste Zurücksetzschaltung ist, um ein Zurücksetzsignal an eine erste Steuervorrichtung bereitzustellen, und wobei die Zurücksetzvorrichtung ferner eine zweite Zurücksetzschaltung (103-2), umfasst, um ein Zurücksetzsignal an eine zweite Steuervorrichtung (201) bereitzustellen, wobei die erste Verzögerungsschaltung (101) dazu konfiguriert ist, die erste Zurücksetzschaltung und die zweite Zurücksetzschaltung (103-2) auszulösen, um die jeweiligen Zurücksetzsignale bereitzustellen, wenn die erste Spannung eine erste Schwellenbedingung relativ zu der zweiten Spannung erfüllt;
wobei die zweite Zurücksetzschaltung (103-2) optional dazu konfiguriert ist, das jeweilige Zurücksetzsignal nur dann an die zweite Steuervorrichtung bereitzustellen, wenn die erste Spannung eine dritte Schwellenbedingung erfüllt.

12. Zurücksetzvorrichtung (100) nach einem der vorstehenden Ansprüche, wobei der physikalische Stecker ein USB-Stecker ist.

13. Motorbaugruppe (200), die umfasst:
einen Motor (202);
eine Steuervorrichtung zum Steuern des Motors;
einen Anschluss (203) zum Aufnehmen eines spannungszuführenden physikalischen Steckers; und
eine Zurücksetzvorrichtung nach einem der Ansprüche 1-12, die angeordnet ist, um eine Spannung von einem physikalischen Stecker, der in dem Anschluss aufgenommen ist, zu empfangen und ein Zurücksetzsignal an die Steuervorrichtung bereitzustellen.

14. Motor (202) nach Anspruch 13, der ferner eine Batterie für die Stromversorgung des Motors umfasst, wobei die Batterie angeordnet ist, um durch einen in dem Anschluss aufgenommenen physikalischen Stecker geladen zu werden.

15. Motorisierte Jalousie (400), die die Motorbaugruppe nach Anspruch 13 oder 14 umfasst.

## Revendications

1. Dispositif de réinitialisation (100) pour réinitialiser un dispositif de commande (201) d'un moteur (202), le dispositif comprenant :
un premier circuit à retard (101) conçu pour décharger une première tension (U1(t)) à une première vitesse (R1),
un deuxième circuit à retard (102) conçu pour décharger une deuxième tension (U2(t)) à une deuxième vitesse (R2), la première vitesse étant inférieure à la deuxième vitesse, et
un circuit de réinitialisation (103) conçu pour fournir un signal de réinitialisation au dispositif de commande ;
le premier circuit à retard (101) et le deuxième circuit à retard (102) étant disposés pour être chargés à partir d'un connecteur physique (300) et pour se décharger lors du retrait du connecteur physique,
le premier circuit à retard (101) déclenchant le circuit de réinitialisation de façon qu'il fournisse le signal de réinitialisation lorsque la première tension remplit une première condition seuil par rapport à la deuxième tension,
la valeur maximale de la première tension stockée par le premier circuit à retard (101) étant inférieure à la valeur maximale de la deuxième tension stockée par le deuxième circuit à retard (102), et
la première condition seuil étant que la première tension dépasse la deuxième tension d'une quantité minimale.

2. Dispositif de réinitialisation selon la revendication 1, le dispositif de réinitialisation comprenant un premier élément de commutation (104) assurant la connexion commutable du premier circuit à retard (101) au circuit de réinitialisation, le premier élément de commutation étant conçu pour connecter le premier circuit à retard (101) au circuit de réinitialisation uniquement si la première tension remplit la première condition seuil.

3. Dispositif de réinitialisation (100) selon la revendication 2, dans lequel le premier élément de commutation est un premier transistor (T1) commandé par porte par le deuxième circuit à retard (102) de façon que le premier circuit à retard (101) est connecté au circuit de réinitialisation lorsque la première condition seuil est remplie.

4. Dispositif de réinitialisation (100) selon l'une quelconque des revendications précédentes, dans lequel le circuit de réinitialisation est conçu pour fournir le signal de réinitialisation au dispositif de commande uniquement lorsque la première tension remplit une deuxième condition seuil.

5. Dispositif de réinitialisation (100) selon la revendication 4, dans lequel le circuit de réinitialisation comprend un deuxième élément de commutation (105) conçu pour assurer la connexion commutable du dispositif de commande à une tension de réinitialisation, le deuxième élément de commutation étant conçu pour connecter le dispositif de commande à la tension de réinitialisation lorsque la première tension remplit la deuxième condition seuil.

6. Dispositif de réinitialisation (100) selon la revendication 5, dans lequel la tension de réinitialisation est basse, de masse ou nulle.

7. Dispositif de réinitialisation (100) selon la revendication 5 ou 6, dans lequel la deuxième condition seuil est que la première tension est supérieure à une quantité fixe.

8. Dispositif de réinitialisation (100) selon la revendication 7, dans lequel le deuxième élément de commutation est un deuxième transistor (T2) commandé par porte par le premier circuit à retard (101), la deuxième condition seuil étant que la première tension est supérieure à une tension de grille du deuxième transistor.

9. Dispositif de réinitialisation (100) selon l'une quelconque des revendications précédentes, dans lequel le premier circuit à retard (101), le deuxième circuit à retard (103-2) et/ou le circuit de réinitialisation sont constitués de composants analogiques.

10. Dispositif de réinitialisation (100) selon la revendication 9, dans lequel le premier circuit à retard (101) et/ou le deuxième circuit à retard (102) comprennent un circuit RC.

11. Dispositif de réinitialisation (100) selon l'une quelconque des revendications précédentes, dans lequel le circuit de réinitialisation est un premier circuit de réinitialisation permettant de fournir un signal de réinitialisation à un premier dispositif de commande, le dispositif de réinitialisation comprenant en outre un deuxième circuit de réinitialisation (103-2) permettant de fournir un signal de réinitialisation à un deuxième dispositif de commande (201), le premier circuit à retard (101) étant conçu pour déclencher le premier circuit de réinitialisation et le deuxième circuit de réinitialisation (103-2) pour fournir les signaux de réinitialisation respectifs lorsque la première tension remplit une première condition seuil par rapport à la deuxième tension ;
le deuxième circuit de réinitialisation (103-2) étant éventuellement conçu pour fournir le signal de réinitialisation respectif au deuxième dispositif de commande uniquement si la première tension remplit une troisième condition seuil.

12. Dispositif de réinitialisation (100) selon l'une quelconque des revendications précédentes, dans lequel le connecteur physique est un connecteur USB.

13. Ensemble moteur (200) comprenant :
un moteur (202),
un dispositif de commande pour commander le moteur,
une prise (203) pour recevoir un connecteur physique fournissant une tension, et
un dispositif de réinitialisation selon l'une quelconque des revendications 1 à 12 disposé pour recevoir une tension à partir d'un connecteur physique reçu dans la prise et pour fournir un signal de réinitialisation au dispositif de commande.

14. Moteur (202) selon la revendication 13, comprenant en outre une batterie pour alimenter le moteur, la batterie étant agencée pour être chargée par un connecteur physique reçu dans la prise.

15. Store motorisé (400) comprenant l'ensemble moteur selon la revendication 13 ou 14.
